(19) Europäisches Patentamt
European Patent Office
Office européen des brevets

(11) Veröffentlichungsnummer: **0 243 831**
**A2**

# (12) EUROPÄISCHE PATENTANMELDUNG

(21) Anmeldenummer: **87105758.4**

(51) Int. Cl.⁴: **C08G 65/40**, C08G 75/23

(22) Anmeldetag: **18.04.87**

(30) Priorität: **30.04.86 DE 3614594**

(43) Veröffentlichungstag der Anmeldung: **04.11.87 Patentblatt 87/45**

(84) Benannte Vertragsstaaten: **BE DE FR GB NL**

(71) Anmelder: **BASF Aktiengesellschaft**
**Carl-Bosch-Strasse 38**
**D-6700 Ludwigshafen(DE)**

(72) Erfinder: **Heinz, Gerhard, Dr.**
**Im Vogelsang 2**
**D-6719 Weisenheim(DE)**
Erfinder: **Buchert, Hermann, Dr.**
**An der Nolzeruhe 8 c**
**D-6702 Bad Duerkheim(DE)**
Erfinder: **Koch, Juergen, Dr.**
**Woogstrasse 36**
**D-6708 Neuhofen(DE)**
Erfinder: **Simon, Georg Nikolaus, Dr.**
**Untere Hart 10**
**D-6703 Limburgerhof(DE)**
Erfinder: **Ittemann, Peter, Dr.**
**Wilhelm-Busch-Strasse 87**
**D-6700 Ludwigshafen(DE)**
Erfinder: **Zeiner, Hartmut, Dr.**
**Johann-Strauss-Strasse 13**
**D-6831 Plankstadt(DE)**

## (54) Hochtemperaturbeständige Formmassen.

(57) Hochtemperaturbeständige Formmassen, enthaltend

EP 0 243 831 A2

Xerox Copy Centre

A) 5-95 mol% Blöcke mit der Struktureinheit I

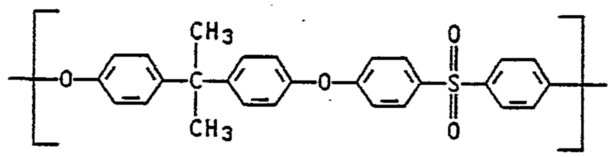

(I)

B) 5-95 mol% Blöcke mit der Struktureinheit II

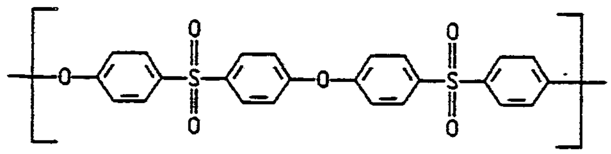

(II)

C) 0-80 mol% Blöcke mit der Struktureinheit III

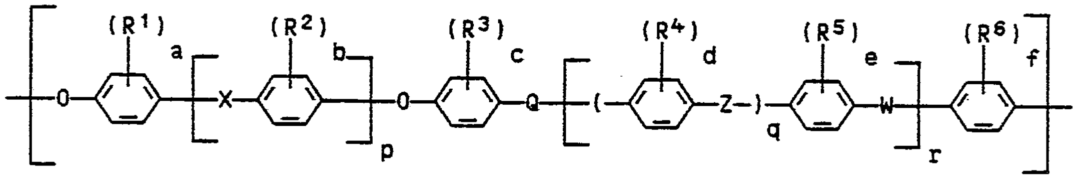

(III)

wobei das Molekulargewicht der Blöcke im Bereich von 2000 - 20 000 liegt und
X -0-, -S-,

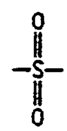

(nur wenn a oder b ≠ 0), $-\overset{O}{\overset{\parallel}{C}}-$,

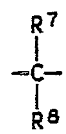

($R^7$ = $R^8$ = $CH_3$, nur wenn a oder b ≠ 0) oder eine chemische Bindung,
$R^7$ und $R^8$ Alkoxy-oder Alkylgruppen mit 1-6 C-Atomen, Arylgruppen oder Wasserstoffatome,
Q, W $-\overset{O}{\overset{\parallel}{C}}-$ oder

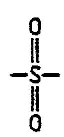,

Z -0-oder eine chemische Bindung und
$R^1$, $R^2$, $R^3$, $R^4$, $R^5$ und $R^6$ Alkyl-oder Alkoxygruppen mit 1-6 C-Atomen, Arylgruppen, Cl oder F darstellen und
p, q, r den Wert 0 oder 1 und
a, b, c, d und e den Wert 0, 1, 2, 3 oder 4 haben.

## Hochtemperaturbeständige Formmassen

Die Erfindung betrifft hochtemperaturbeständige Formmassen, enthaltend

A) 5-95 mol% Blöcke mit der Struktureinheit I

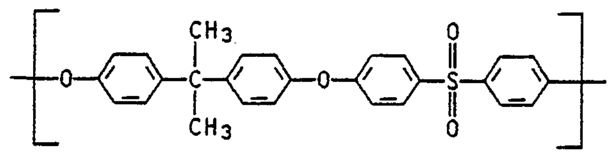

(I)

B) 5-95 mol% Blöcke mit der Struktureinheit II

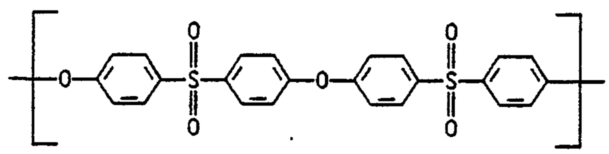

(II)

C) 0-80 mol% Blöcke mit der Struktureinheit III

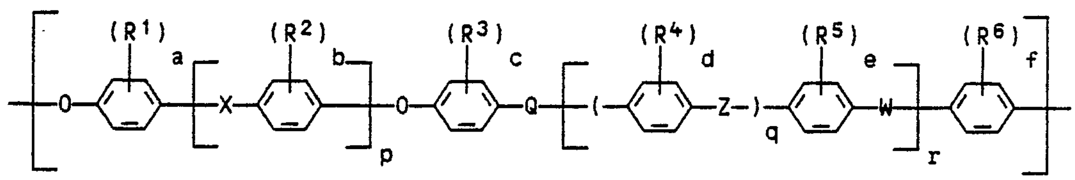

(III)

wobei das Molekulargewicht der Blöcke im Bereich von 2000 - 20 000 liegt und
X -0-, -S-,

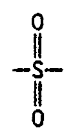

(nur wenn a oder b ≠ 0), - 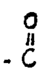 -,

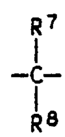

($R^7$ = $R^8$ = $CH_3$, nur wenn a oder b ≠ 0) oder eine chemische Bindung,
$R^7$ und $R^8$ Alkoxy-oder Alkylgruppen mit 1-6 C-Atomen, Arylgruppen oder Wasserstoffatome,
Q, W - 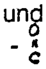 -oder

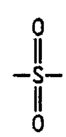 ,

Z -0-oder eine chemische Bindung und
$R^1$, $R^2$, $R^3$, $R^4$, $R^5$ und $R^6$ Alkyl-oder Alkoxygruppen mit 1-6 C-Atomen, Arylgruppen, Cl oder F darstellen und

p, q, r den Wert 0 oder 1 und
a, b, c, d und e den Wert 0, 1, 2, 3 oder 4 haben.

Außerdem betrifft die Erfindung die Verwendung der erfindungsgemäßen Formmassen zur Herstellung von Leiterplatten und elektrischen Steckverbindungen.

Polyethersulfone mit der allgemeinen Struktureinheit (häufig, wie auch im folgenden, einfach als Polysulfone bezeichnet)

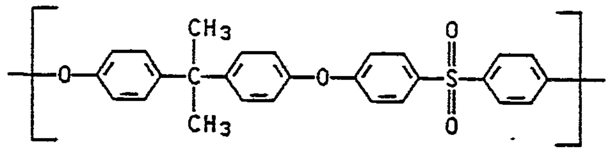

zeichnen sich durch eine sehr geringe Wasseraufnahme und damit eine sehr geringe Neigung zum Verzug (der daraus hergestellten Formteile) aus. Die Wärmeformbeständigkeit (bestimmt über die maximale Dauergebrauchstemperatur) ist jedoch für einige Anwendungszwecke, insbesondere bei aus den Formmassen hergestellten Leiterplatten (printed circuit boards, auch PCB genannt) nicht ausreichend.

Polyethersulfone mit der allgemeinen Struktureinheit

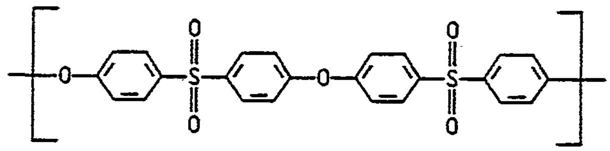

weisen im Vergleich zu Polysulfonen eine bessere Wärmeformbeständigkeit auf, doch ist die Wasseraufnahme wesentlich höher. Dies hat zur Folge, daß Formteile aus Polyethersulfonen eine unbefriedigende Formstabilität aufweisen und z.B. zur Quellung und zum Verzug neigen, was bei der Verwendung in der Elektrotechnik und Elektronik (z.B. für Leiterplatten für gedruckte Schaltungen) nicht akzeptabel ist.

Mischungen aus Polysulfonen und Polyethersulfonen zeigen einen linearen Zusammenhang zwischen Mischungsverhältnis und Wasseraufnahme, jedoch wird die Wärmeformbeständigkeit durch den Polysulfon-Anteil negativ beeinflußt. Zudem sind Formteile aus derartigen Mischungen infolge der Unverträglichkeit der beiden Komponenten nicht mehr transparent, was einen wesentlichen Nachteil darstellt.

In der US-A 4 175 175 und der EP-A 113 112 sowie der EP-A 195 130 werden statistische Copolykondensate beschrieben, die durch Polykondensation von Mischungen aus 2,2-Di(4-hydroxyphenyl)-propan (Bisphenol A) und 4,4'-Di hydroxydiphenylsulfon (Bisphenol S) mit 4,4'-Dichlordiphenylsulfon (DCDPS) erhätlich sind.

Der Erfindung lag die Aufgabe zugrunde, hochtemperaturbeständige Copolykondensate mit einem ausgewogenen Eigenschaftsspektrum, d.h. einer ausreichenden Wärmeformbeständigkeit bei geringer Wasseraufnahme und hoher Spannungsrißbeständigkeit zur Verfügung zu stellen, die sich insbesondere zur Herstellung von Leiterplatten (printed circuit boards) und elektrischen Steckverbindungen eignen.

Diese Aufgabe wird erfindungsgemäß gelöst durch hochtemperaturbeständige Formmassen gemäß Anspruch 1.

Bevorzugte Copolykondensate dieser Art sind den Unteransprüchen und der nachfolgenden detaillierten Beschreibung zu entnehmen.

Die Blöcke der allgemeinen Struktur I leiten sich von der Kondensation von Bisphenol A (2,2-Di-(4'-hydroxyphenyl)propan) mit 4,4'-Dichlordiphenylsulfon bzw. der entsprechenden Fluorverbindung ab, die Blöcke der allgemeinen Struktur II von der Kondensation von Bisphenol S (4,4'-Dihydroxydiphenylsulfon) mit diesen Dihalogenverbindungen.

Die Blöcke der Struktur III leiten sich von der Kondensation von Dihydroxyverbindungen der allgemeinen Formel IV

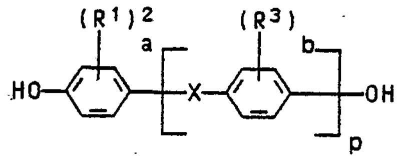 (IV)

und Dihalogenverbindungen der allgemeinen Formel V

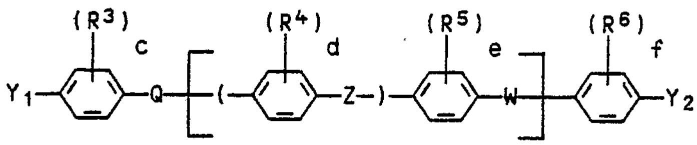 (V)

ab, wobei $R^1$ -$R^6$, a - f, X, Q, Z und W die in Anspruch 1 angegebenen Bedeutungen haben und $Y_1$ und $Y_2$ Cl oder F sind.

Vorzugsweise sind $R^1$ und $R^2$ Alkylgruppen mit 1-4 C-Atomen, z.B. Methyl-, Ethyl-, i-oder n-Propyl, i-, n-oder t-Butyl, entsprechende Alkoxygruppen oder auch Arylgruppen.

Zu beachten ist, daß für den Fall, daß

X = 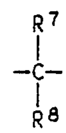 ,

$R^7$ und $R^8$ nur dann beide eine Methylgruppe sein können, wenn mindestens ein Substituent $R^1$ oder $R^2$ vorhanden ist, d.h. wenn entweder a und/oder b $\neq$ O sind. Vorzugsweise haben a und b den Wert 0,1 oder 2.

p kann 0 oder 1 sein, d.h. die Dihydroxyverbindung kann einen oder zwei Phenylringe enthalten.

Nachstehend seien stellvertretend einige bevorzugte Dihydroxyverbindungen der allgemeinen Formel IV aufgeführt.

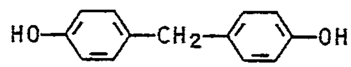

Di-(4-hydroxyphenyl)methan

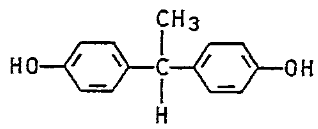

2,2-Di(4-hydroxyphenyl)ethan

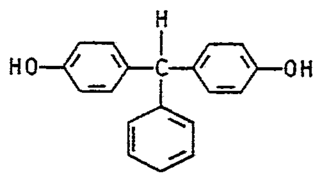

1-Phenyl-1,1-di-(4-hydroxyphenyl)-methan

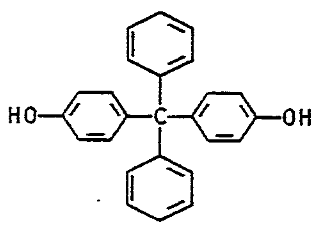

Diphenyl-di-(4-hydroxyphenyl)methan

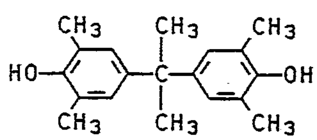

Tetramethylbisphenol A

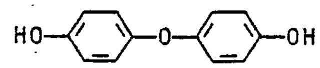

4,4'-Dihydroxydiphenylether

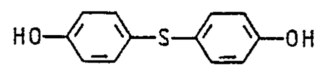

4,4'-Dihydroxydiphenylsulfan

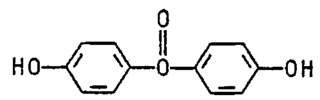

Dihydroxybenzophenon

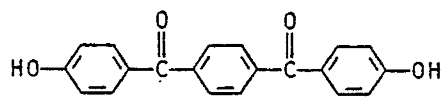

1,4-Di(4'-hydroxycarbonylphenyl)benzol

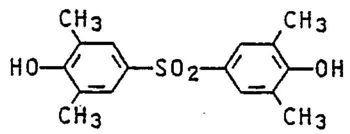

Tetramethylbisphenol S

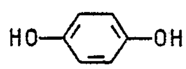

Hydrochinon

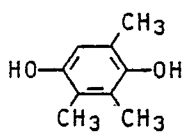

2,3,6-Trimethylhydrochinon

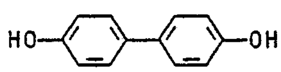

4,4'-Dihydroxydiphenyl

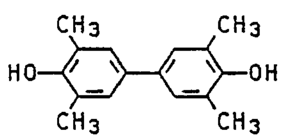

3,3',5,5'-Tetramethyldihydroxydiphenyl

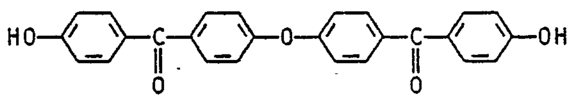

Dihydroxybenzophenylether

Von den vorstehend aufgeführten Dihydroxyverbindungen werden 4,4'-Dihydroxydiphenyl, 3,3',5,5'-Tetramethyl-4,4'-dihydroxydiphenyl, Tetramethyl-Bisphenol A und 2,3,6-Trimethylhydrochinon besonders bevorzugt.

In den Dihalogenverbindungen der vorstehend genannten allgemeinen Formel sind die Substituenten $R^3$, $R^4$, $R^5$ und $R^6$ vorzugsweise Alkylgruppen mit 1-4 C-Atomen, z.B. Methyl, i-oder n-Propyl oder t-Butyl oder Cl oder F.

Die folgenden Dihalogenverbindungen der allgemeinen Formel V seien stellvertretend als bevorzugte Beispiele aufgeführt.

Bezeichnung der Chlorverbindung

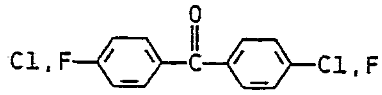

4,4'-Dichlorbenzophenon

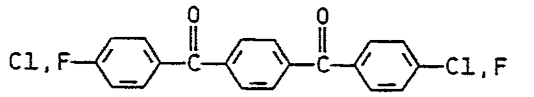

1,4-Di(4'-chlorcarbonylphenyl)-benzol

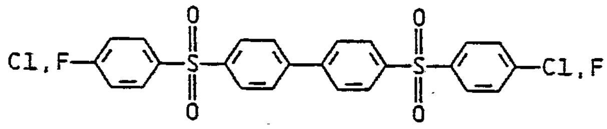

1,10-Di-(4'-chlorphenylsulfon)-diphenyl

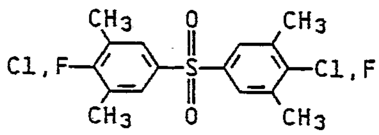

3,3',5,5'-Tetramethyl-4,4'-dichlordiphenylsulfon

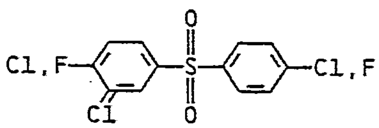

3'-Chlor-4,4'-Dichlordiphenyl-sulfon

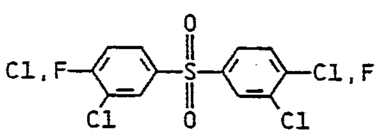

3,3',4,4'-Tetrachlordiphenyl-sulfon

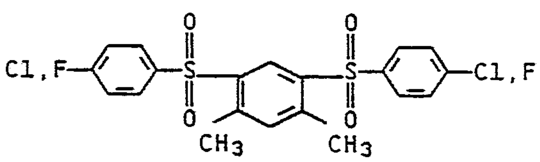

1,3-Dimethyl-4,6-di(4'-chlor-phenylsulfon)benzol

Von den vorstehend aufgeführten Dihalogenverbindungen werden 3,3',5,5'-Tetramethyl-4,4'-dichlordiphenylsulfon, 1,10-Di(4'-Chlorphenylsulfondiphenyl und 1,3-Dimethyl-4,6-di-(4'-chlorphenylsulfon)benzol besonders bevorzugt.

Der Anteil der Blöcke A der Struktur I beträgt 5-95, vorzugsweise 20-80 und insbesondere 40-60 mol%, bezogen auf die Summe der Blöcke A-C. Entsprechendes gilt für den molaren Anteil der Blöcke B der allgemeinen Struktur II.

Der Anteil der Blöcke C der Struktur III beträgt 0-80, vorzugsweise 0-60 und insbesondere 5-50 mol%. Ein Gehalt von 10-40 mol% ist ganz besonders bevorzugt.

Das Molekulargewicht der Blöcke A, B und C liegt im Bereich von 2000 - 20 000, insbesondere von 2000 - 15 000, besonders bevorzugt im Bereich von 4000 - 12 000.

Das Gesamtmolekulargewicht der Blockcopolykondensate liegt im Bereich von 15 000 - 200 000, vorzugsweise von 15 000 - 100 000 und insbesondere im Bereich von 20 000 - 50 000.

Alle vorstehend genannten Molekulargewichtswerte sind Gewichtsmittelwerte, wie sie z.B. in E. Vollmert, Grundriß der Makromolekularen Chemie, Bd. 3, S. 122 ff (1979) definiert sind.

Die Copolykondensate können mit anderen Thermoplasten, beispielsweise Polyestern, Polyamiden, Polyurethanen, Polyolefinen, Polyvinylchlorid und Polyoxymethylenen in Mengen von 5 bis 60 Gew.-%, vorzugsweise von 20 bis 50 Gew.-%, bezogen auf die Formmassen, gemischt werden.

Sie können außerdem mit verstärkend wirkenden Füllstoffen, gegebenenfalls transparenten Pigmenten und anderen Hilfs-und Zusatzstoffen modifiziert werden.

Als verstärkend wirkende Füllstoffe seien beispielsweise Asbest, Kohle und vorzugsweise Glasfasern genannt, wobei die Glasfasern z.B. in Form von Glasgeweben, -matten, -vliesen und/oder vorzugsweise Glasseidenrovings oder geschnittener Glasseide aus alkaliarmen E-Glasen mit einem Durchmesser von 5 bis 20 µm, vorzugsweise 8 bis 15 µm, zur Anwendung gelangen, die nach ihrer Einarbeitung eine mittlere Länge von 0,05 bis 1 mm, vorzugsweise 0,1 bis 0,5 mm, aufweisen. Die mit Glasseidenrovings oder geschnittener Glasseide verstärkten Formmassen enthalten zwischen 10 und 60 Gew.-%, vorzugsweise 20 bis 50 Gew.-%, des Verstärkungsmittels, bezogen auf das Gesamtgewicht, während die imprägnierten Glasgewebe, -matten und/oder -vliese zwischen 10 und 80 Gew.-%, vorzugsweise zwischen 30 und 60 Gew.-%, Copolykondensate, bezogen auf das Gesamtgewicht, enthalten. Als Pigmente eignen sich beispielsweise Titandioxid, Cadmium-, Zinksulfid, Bariumsulfat und Ruß. Als andere Zusatz-und Hilfsstoffe kommen beispielsweise in Betracht Farbstoffe, Schmiermittel, wie z.B. Graphit oder Molybdändisulfid, Schleifmittel, wie z.B. Carborund, Lichtstabilisatoren und Hydrolyseschutzmittel. Auch Wollastonit, Calciumcarbonat, Glaskugeln, Quarzmehl, S und Bornitrid oder Mischungen dieser Farbstoffe sind verwendbar. Die Pigmente, Zusatz-und Hilfsstoffe werden üblicherweise in Mengen von 0,01 bis 3 Gew.-%, bezogen auf das Gewicht an Copolykondensat, eingesetzt.

Die erfindungsgemäßen Formmassen können nach an sich bekannten Verfahren zur Herstellung von Blockcopolymeren hergestellt werden, wie sie in der Literatur beschrieben sind. Grundsätzlich können die Blöcke A, B und C getrennt hergestellt und anschließend miteinander verknüpft werden oder aber die Blockcopolykondensate werden durch entsprechende aufeinanderfolgende getrennte Zugabe der Dihydroxyverbindungen in einem Zuge synthetisiert.

Die Verfahrensbedingungen wie Temperatur, Druck, geeignete Lösungsmittel und evtl. Zusätze (Katalysatoren) sind die gleichen, wie sie für statistische Copolykondensate in der EP-A 113 112 und der EP-A 135 130 beschrieben sind, so daß sich hier nähere Angaben erübrigen.

Besonders geeignet ist die Umsetzung in aprotischen polaren Lösungsmitteln in Gegenwart von wasserfreien Alkalicarbonaten als Katalysatoren. Eine besonders bevorzugte Kombination ist N-Methylpyrrolidon als Lösungsmittel und $K_2CO_3$ als Katalysator.

Im Anschluß an die Polykondensation können zur Stabilisierung freie Phenolat-Endgruppen mit einem Aryl-oder Alkylierungsmittel, wie z.B. Methylchlorid, umgesetzt werden. Dies erfolgt vorzugsweise bei Temperaturen von 50-200°C, vorzugsweise 50-150°C.

Das bei der Polykondensation mit $K_2CO_3$ als Katalysator anfallende suspendierte Alkalihalogenid kann mit einer geeigneten Trenneinrichtung, beispielsweise einem Klärfilter oder einer Zentrifuge abgetrennt werden.

Die Isolierung der Copolykondensate aus der Lösung kann durch Verdampfen des Lösungsmittels oder Ausfällung in einem geeigneten Nichtlösungsmittel erfolgen.

Die erfindungsgemäßen Formmassen zeichnen sich durch ihre ausgewogenen Eigenschaften aus. Bei einer hohen Wärmeformbeständigkeit und einer guten Spannungsrißbeständigkeit zeichnen sie sich durch eine geringe Wasseraufnahme aus und sind sehr gut verarbeitbar.

Die erfindungsgemäßen Formmassen können zur Herstellung von Formkörpern, Folien und Fasern verwendet werden. Insbesondere eignen sie sich wegen ihrer guten Eigenschaften zur Herstellung von Leiterplatten und elektrischen Steckverbindungen.

Beispiele 1 - 7

Stufe I:

Eine Mischung aus Dichlordiphenylsulfon, Bisphenol A (in den in der Tabelle angegebenen Mengen) und Kaliumcarbonat (letzteres in 10%igem molaren Überschuß, bezogen auf die Summe der Monomeren in Stufe I) wurden in der doppelten Gewichtsmenge einer Mischung aus N-Methylpyrrolidon und Chlorbenzol (Gewichtsverhältnis 3:1) unter Rühren und Einleiten von Stickstoff auf 170°C erhitzt. Das entstandene Reaktionswasser wurde 4 h lang mit Hilfe eines Wasserabscheiders entfernt. Anschließend wurde 4 h bei 190°C weiter kondensiert.

Stufe II:

Nach Zugabe der in der Tabelle angegebenen Monomeren für die Stufe II, Kaliumcarbonat (wiederum in 10%igem molaren Überschuß, bezogen auf die Summe der Monomeren der Stufe II) und der 1,5-fachen Gewichtsmenge (bezogen auf die Summe der Monomeren der Stufe II) N-Methylpyrrolidon wurde das Reaktionsgemisch 2 h auf 170°C erhitzt und anschließend die Reaktion bei 190°C 6 h fortgesetzt. Durch 30-minütiges Einleiten von Methylchlorid wurde die Polykondensation abgebrochen.

Durch Fällung mit Wasser wurden die Polymeren isoliert, zur Entfernung von anorganischen Bestandteilen mehrmals mit Wasser gewaschen und im Vakuum bei 80°C getrocknet.

Die Ergebnisse der Messungen der maximalen Dauergebrauchstemperatur (Wärmeformbeständigkeit Tg) und der Wasseraufnahme nach 180 Tagen sind der Tabelle zu entnehmen, in der weiterhin folgende Abkürzungen verwendet werden:

DCDPS = 4,4'-Dichlordiphenylsulfon
Bis A = 2,2-Di(4'-hydroxyphenyl)propan (Bisphenol A)
DHDPS = 4,4'-Dihydroxydiphenylsulfon
$M_{PSU}$ = Molekulargewicht der Polysulfon-Blöcke (Gewichtsmittelwert)
Tg = maximale Dauergebrauchstemperatur in °C

Tabelle

| Bsp.-Nr. | Stufe I | | Stufe II | | $M_{PSU}$ | Tg | Viskositätszahl | Wasseraufnahme (180 Tage) | |
|---|---|---|---|---|---|---|---|---|---|
| | DCDPS | Bis A | DHDPS | DCDPS | | °C | DIN 53 726/8 | Normklima [1)] | $H_2O$ |
| | g (mol) | g (mol) | g (mol) | g (mol) | | | | Gew.% | Gew.% |
| 1 | 248,70 (0,866) | 204,09 (0,894) | 33,79 (0,1350) | 29,87 (0,104) | 15000 | 195 | 65 | 0,10 | 0,69 |
| 2 | 272,25 (0,948) | 237,42 (1,04) | 236,56 (0,945) | 305,56 (1,064) | 4800 | 211 | 68 | 0,13 | 1,06 |
| 3 | 276,84 (0,964) | 231,03 (1,01) | 241,3 (0,964) | 304,4 (1,06) | 9000 | 207 | 85 | 0,14 | 1,04 |
| 4 | 277,9 (0,968) | 227,4 (0,996) | 242,3 (0,968) | 305,6 (1,064) | 15000 | 204 | 71 | 0,13 | 1,05 |
| 5 | 236,64 (0,824) | 193,59 (0,848) | 280,30 (1,12) | 346,91 (1,21) | 15000 | 216 | 69 | 0,17 | 1,25 |
| 6 | 290,6 (1,01) | 226,9 (0,964) | 265,3 (1,06) | 276,8 (0,96) | 9000 | 208 | 79 | 0,15 | 1,05 |
| | Stufe II | | Stufe I | | | | | | |
| 7 | 277,9 (0,968) | 227,4 (0,996) | 242,3 (0,968) | 305,6 (1,064) | 15000 | 206 | 70 | 0,14 | 1,05 |

1) Normklima: 23°C, 50 % relative Luftfeuchtigkeit

## Ansprüche

1. Hochtemperaturbeständige Formmassen, enthaltend

A) 5-95 mol% Blöcke mit der Struktureinheit I

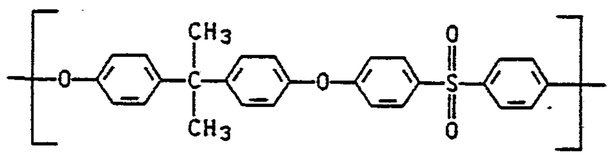

(I)

B) 5-95 mol% Blöcke mit der Struktureinheit II

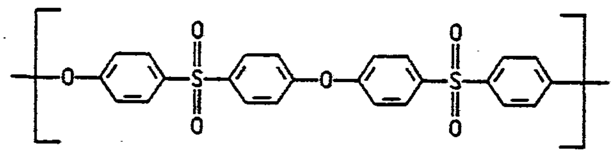

(II)

C) 0-80 mol% Blöcke mit der Struktureinheit III

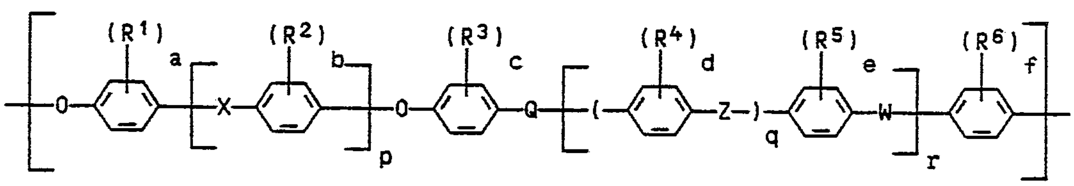

(III)

wobei das Molekulargewicht der Blöcke im Bereich von 2000 - 20 000 liegt und X -0-, -S-,

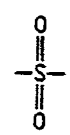

(nur wenn a oder b ≠ 0), - 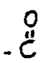 -,

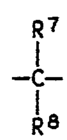

($R^7$ = $R^8$ = $CH_3$, nur wenn a oder b ≠ 0) oder eine chemische Bindung,
$R^7$ und $R^8$ Alkoxy-oder Alkylgruppen mit 1-6 C-Atomen, Arylgruppen oder Wasserstoffatome,
Q, W - 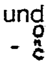 -oder

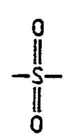 ,

Z -0-oder eine chemische Bindung und

$R^1$, $R^2$, $R^3$, $R^4$, $R^5$ und $R^6$ Alkyl-oder Alkoxygruppen mit 1-6 C-Atomen, Arylgruppen, Cl oder F darstellen und

p, q, r den Wert 0 oder 1 und

a, b, c, d und e den Wert 0, 1, 2, 3 oder 4 haben.

2. Hochtemperaturbeständige Formmassen nach Anspruch 1, dadurch gekennzeichnet, daß sie

A) 20-80 mol% Blöcke der Struktureinheit I

B) 20-80 mol% Blöcke der Struktureinheit II

C) 0-50 mol% Blöcke der Struktureinheit III

enthalten.

3. Verwendung der hochtemperaturbeständigen Formmassen nach den Ansprüchen 1 und 2 zur Herstellung von Leiterplatten und elektrischen Steckverbindungen.

4. Formkörper, erhältlich aus hochtemperaturbeständigen Formmassen gemäß Anspruch 1 als wesentliche Komponente.